# EUROPEAN PATENT SPECIFICATION

(11) **EP 4 542 644 B1**
(45) Date of publication and mention of the grant of the patent: **26.08.2026**
(21) Application number: 24204783.5
(22) Date of filing: 04.10.2024
(51) Int. Cl.: H10W 72/20, H10W 70/65, H10W 72/00, H10W 72/29, H10W 72/90

(54) **SEMICONDUCTOR DEVICE WITH SURROUNDING BUMP METALLIZATION AND METHOD THEREFOR**
HALBLEITERBAUELEMENT MIT UMGEBENDER BUMP-METALLISIERUNG UND VERFAHREN DAFÜR
DISPOSITIF SEMI-CONDUCTEUR AVEC MÉTALLISATION DES BOSSES ENVIRONNANTES ET PROCÉDÉ ASSOCIÉ

(30) Priority: 18.10.2023 US 202318489173
(43) Date of publication of application: 23.04.2025
(73) Proprietor: NXP USA, Inc., Austin, TX 78735 (US)
(72) Inventor: MAO, Kuan-Hsiang, 5656AG Eindhoven (NL); FANG, Che Ming, 5656AG Eindhoven (NL); CHUANG, Wen Yuan, 5656AG Eindhoven (NL); HUANG, Wen Hung, 5656AG Eindhoven (NL)
(74) Representative: Schwarzweller, Thomas

(56) References cited:
- JP-B2- 4 693 855
- US-A1- 2019 148 317

## Description

### Background

### Field

This disclosure relates generally to semiconductor device packaging, and more specifically, to a semiconductor device with a surrounding bump metallization and method of forming the same.

### Related Art

Today, there is an increasing trend to include sophisticated semiconductor devices in products and systems that are used every day. These sophisticated semiconductor devices may include features for specific applications which may impact the configuration of the semiconductor device packages, for example. For some features and applications, the configuration of the semiconductor device packages may be susceptible to lower reliability, lower performance, and higher product or system costs. Accordingly, significant challenges exist in accommodating these features and applications while minimizing the impact on semiconductor devices' reliability, performance, and costs.

US20190148317A1 describes a semiconductor device having an under bump metallurgy layer (UBM) formed over a first substrate. The UBM shows a first protrusion, the first protrusion having two semicircular parts.
JP4693855B2 describes a semiconductor package, having a rewiring layer formed on a substrate and sealed with an insulating resin. A solder bump is located at an electrode pad opening, formed on the rewiring layer. A ring shape convex structure is located on the periphery of the electrode pad opening.

### Brief Description of the Drawings

The present invention is illustrated by way of example and is not limited by the accompanying figures, in which like references indicate similar elements. Elements in the figures are illustrated for simplicity and clarity and have not necessarily been drawn to scale.
FIG. 1 illustrates, in a simplified plan view, an example semiconductor device having a surrounding bump metallization structure in accordance with an embodiment.
FIG. 2 through FIG. 8 illustrate, in simplified cross-sectional views, the example semiconductor device taken along line A-A of FIG. 1 at various stages of manufacture in accordance with an embodiment.
FIG. 9A through FIG. 9C illustrate, in simplified plan views, example surrounding bump metallization structures of the semiconductor device in accordance with an embodiment.

### Detailed Description

Generally, there is provided, a semiconductor device with a surrounding bump metallization. The semiconductor device includes a patterned redistribution layer. A plurality of interconnections traces are formed from the patterned redistribution layer. Each interconnection trace includes a first portion connected to a top surface of a respective bond pad and a second portion configured as a base for formation of a surrounding bump metallization structure. A plurality of surrounding bump metallization structures are formed on respective interconnection traces. Each of surrounding bump metallization structure includes a plurality of vertical metal wall segments formed around an outer perimeter region of the second portion of the interconnection trace. A central opening or cavity is formed by the surrounding plurality of the vertical metal wall segments. Each of the vertical metal wall segments is separated from a neighboring vertical metal wall segment by a vertical gap. Each of the surrounding bump metallization structures is configured to serve as a socket for receiving a ball connector. The vertical gap allows air to vent as the ball connector material is melted. The width of the gap is chosen such that it is large enough for air to escape and small enough to keep the melted ball connector material from oozing out of the socket. By forming the surrounding bump metallization structures in this manner, the ball connections with semiconductor device are more robust and provide superior reliability along with tighter ball pitch control.

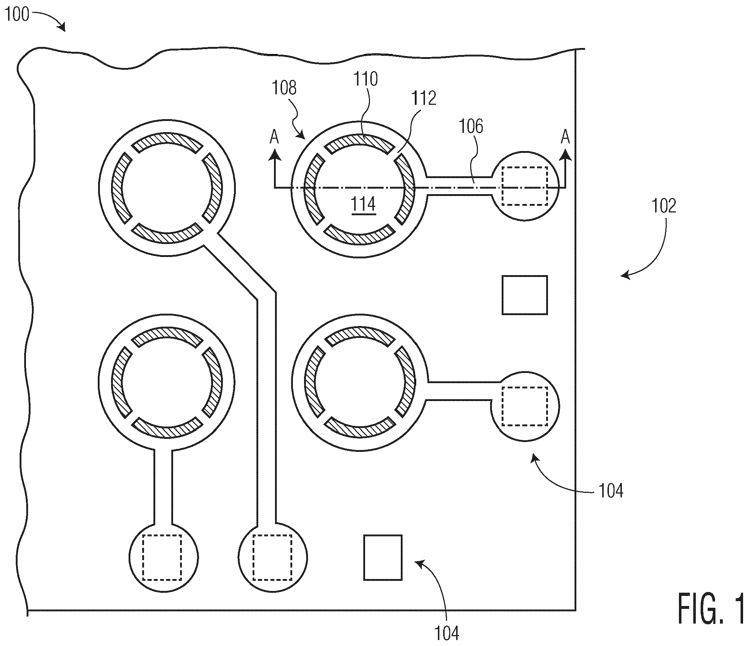

FIG. 1 illustrates, in a simplified plan view, a portion of an example semiconductor device 100 having a surrounding bump metallization (SBM) structure in accordance with an embodiment. The device 100 includes a semiconductor die 102, bond pads 104 formed at the top side of the semiconductor die, conductive (e.g., metal) interconnections traces 106 of a patterned redistribution layer (RDL) formed over the semiconductor die 102, and a plurality of SBM structures 108 formed on respective traces 106. The term "conductive," as used herein, generally refers to electrical conductivity unless otherwise described. In this embodiment, each of the interconnections traces 106 includes a first portion directly connected to a top surface of a respective bond pad 104 and a second portion configured as a base for formation of a SBM structure 108.

In this embodiment, the SBM structure includes a plurality of vertical metal wall segments 110 formed around an outer perimeter region of the second portion of the trace 106. The vertical metal wall segments 110 are arranged to substantially surround a central opening or cavity 114. Each of the vertical metal wall segments 110 is separated from a neighboring vertical metal wall segment by a respective vertical gap 112. The arrangement of the vertical metal wall segments 110 surrounding the central opening 114 may be characterized as a socket structure configured to receive a ball connector (e.g., solder ball) at a subsequent stage of manufacture, for example. The vertical gap 112 is therefore configured to have a predetermined width such that the gap width is large enough to vent air/gas when the ball connector is reflowed yet small enough to prevent reflowed material from extending significantly beyond an outer perimeter formed by the plurality of vertical metal wall segments 110.

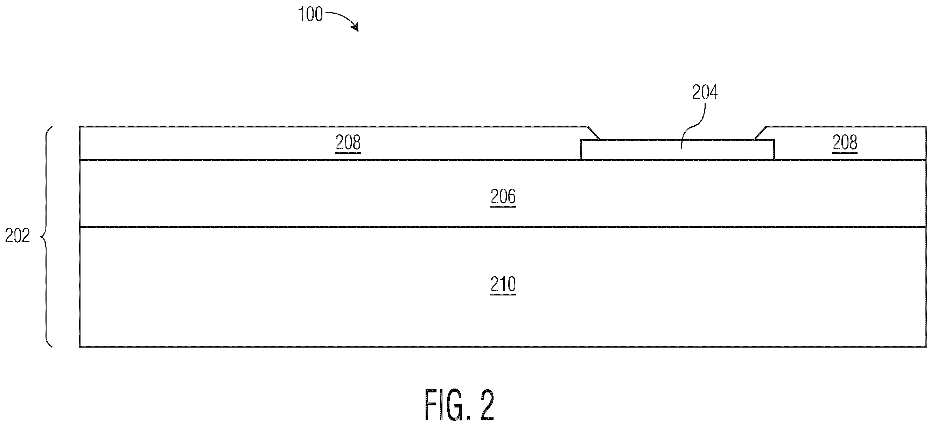

The number, shape, and arrangement of the vertical metal wall segments 110 and RDL interconnection traces 106 are chosen for illustration purposes. Some features of the semiconductor device 100 such as intermediate layers disposed between the semiconductor die 102 and the RDL are not shown for illustration purposes. Even though the embodiment of FIG. 1 is depicted in a "fan-in" configuration, embodiments in other configurations (e.g., "fan-out") are anticipated by this disclosure. Cross-sectional views of the example semiconductor device 100 taken along line A-A of FIG. 1 at stages of manufacture are depicted in FIG. 2 through FIG. 8.

FIG. 2 illustrates, in a simplified cross-sectional view, the example semiconductor device 100 at a stage of manufacture in accordance with an embodiment. At this stage of manufacture, the semiconductor device 100 includes a semiconductor die 202. In this embodiment, the semiconductor die 202 includes a substrate region (e.g., bulk) 210, an active region (e.g., circuitry, interconnect) 206 formed at an active side of the semiconductor die, a bond pad 204 conductively connected to the circuitry and/or interconnect of the active region, and a final passivation layer 208 formed over the active side of the semiconductor die. In some embodiments, the semiconductor die 202 may be provided in a wafer form or portion of a wafer. In some embodiments (e.g., wafer-level chip-scale packaging), the semiconductor device 100 may be include an encapsulant (e.g., epoxy molding compound) formed over the backside of the semiconductor die 202. The semiconductor die 202 may include any number of conductive interconnect layers and passivation layers. For illustration purposes, the bond pad 204 at a top surface and the overlying final passivation layer 208 are depicted. In this embodiment, the semiconductor die 202 depicted in FIG. 2 corresponds to the semiconductor die 102 of FIG. 1.

The semiconductor die 202 is configured and arranged in an active side up orientation. The bond pad 204 at the active side is configured for connection to printed circuit board (PCB) by way of a redistribution layer, SBM structure, and conductive connectors formed at subsequent stages, for example. The semiconductor die 202 may be formed from any suitable semiconductor material, such as silicon, germanium, gallium arsenide, gallium nitride, silicon nitride, silicon carbide, and the like. The semiconductor die 202 may further include any digital circuits, analog circuits, RF circuits, power circuits, memory, processor, MEMS, sensors, the like, and combinations thereof.

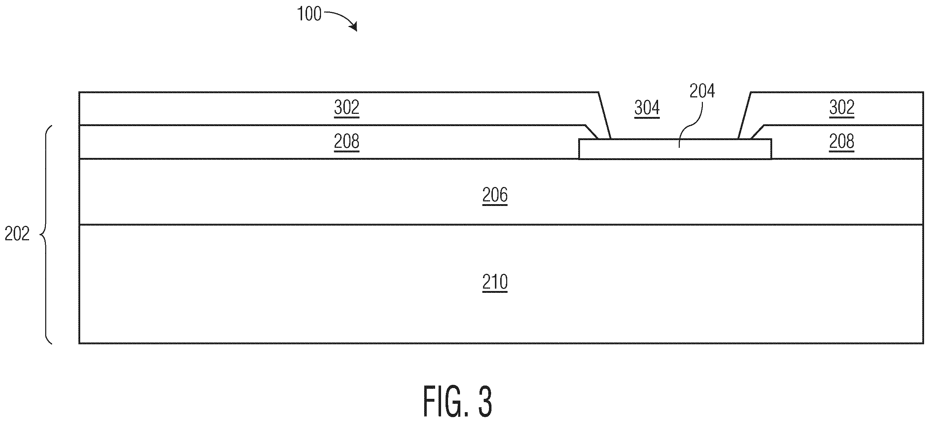

FIG. 3 illustrates, in a simplified cross-sectional view, the example semiconductor device 100 at a subsequent stage of manufacture in accordance with an embodiment. At this stage of manufacture, the semiconductor device 100 includes a first non-conductive (e.g., dielectric) layer 302 formed over the semiconductor die 202. The non-conductive layer 302 is deposited or otherwise applied on the top surface of the semiconductor die 202. The non-conductive layer 302 may be formed from suitable non-conducting polymer materials such as polyimide, PBO, and the like, for example. In this embodiment, the non-conductive layer 302 is patterned to form an opening 304. The opening 304 is located directly over the bond pad 204 such that a substantial portion of the top surface of the bond pad 204 is exposed (e.g., not covered with the non-conductive layer 302).

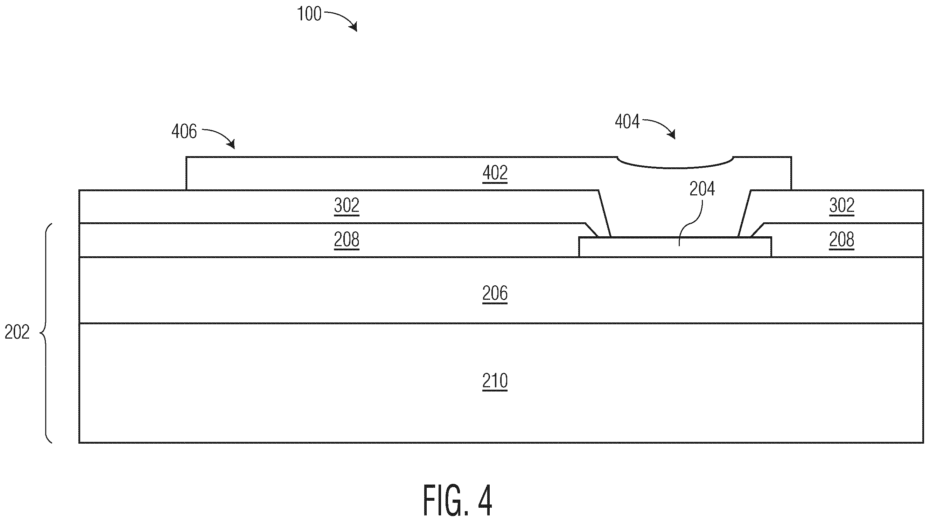

FIG. 4 illustrates, in a simplified cross-sectional view, the example semiconductor device 100 at a subsequent stage of manufacture in accordance with an embodiment. At this stage of manufacture, the semiconductor device 100 includes a metal RDL formed over the non-conductive layer 302 and exposed portion of the bond pad 204. The RDL may be formed by way of sputtering or electroplating a metal material (e.g., copper), for example. In this embodiment, the RDL is patterned to form a plurality of RDL interconnection traces such as the interconnection trace 402 depicted in FIG. 4. The interconnection trace 402 may correspond to the interconnection trace 106 depicted in FIG. 1, for example. In this embodiment, interconnection trace 402 includes a first portion 404 directly connected to the top surface of the bond pad 204 and a second portion 406 configured as a base for formation of an SBM structure at a subsequent stage of manufacture. The interconnection trace 402 is configured to interconnect the bond pad 204 with the SBM structure formed at a subsequent stage, for example.

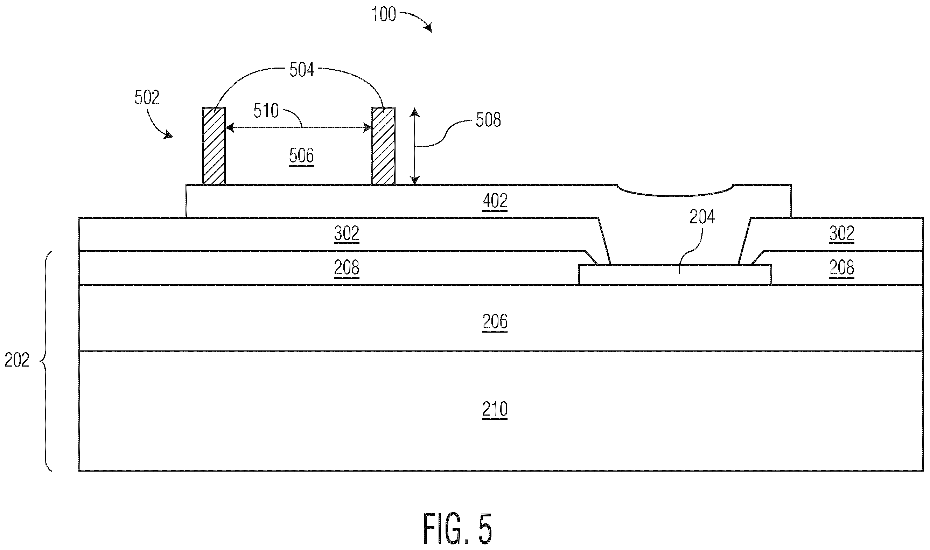

FIG. 5 illustrates, in a simplified cross-sectional view, the example semiconductor device 100 at a subsequent stage of manufacture in accordance with an embodiment. At this stage of manufacture, the semiconductor device 100 includes a metal (e.g., copper) SBM structure 502 formed on the exposed portion of the interconnection trace 402. In this embodiment, the SBM structure includes a plurality of vertical metal wall segments 504 arranged to substantially surround a central opening or cavity 506. Each of the vertical metal wall segments 504 is separated from a neighboring vertical metal wall segment by a respective vertical gap (not shown). The arrangement of the vertical metal wall segments 504 surrounding the central opening 506 may serve as a socket structure for placement of a ball connector (e.g., solder ball) at a subsequent stage of manufacture, for example. In this embodiment, the vertical metal wall segments 504 of the SBM structure 502 maybe formed by way of a plating process. For example, a seed layer (not shown) may be formed and patterned on an exposed portion of the interconnection trace 402 (e.g., second portion 406 of FIG. 4). The plurality of vertical metal wall segments 504 of the SBM structure are formed as electroplated copper pillars by utilizing the patterned seed layer, for example. In this embodiment, the vertical metal wall segments 504 are formed having a substantially uniform height dimension 508 and a (shortest) horizontal width or diameter dimension 510 across the central opening 506. In this embodiment, it is desirable for the height dimension 508 to be approximately in a range of 40-60% of the horizontal width or diameter dimension 510.

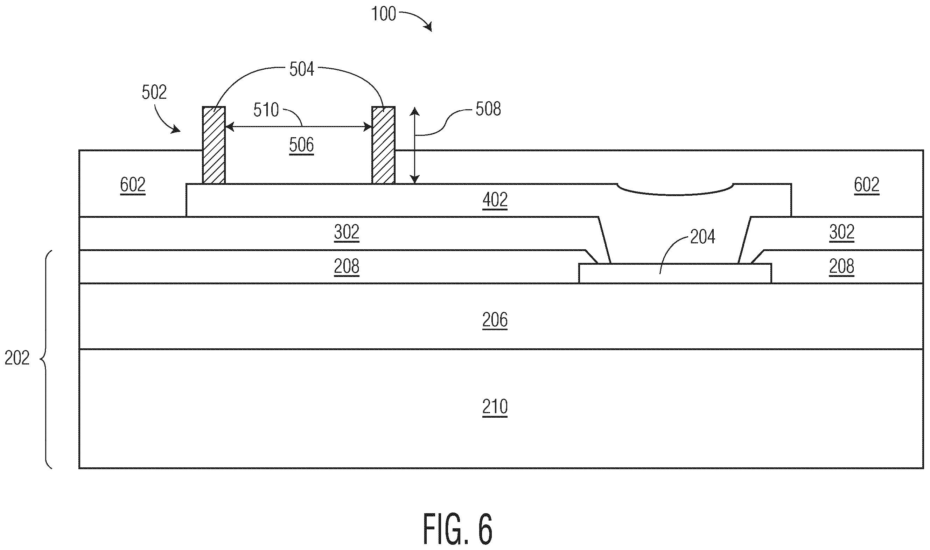

FIG. 6 illustrates, in a simplified cross-sectional view, the example semiconductor device 100 at a subsequent stage of manufacture in accordance with an embodiment. At this stage of manufacture, the semiconductor device 100 includes a second non-conductive (e.g., dielectric) layer 602 formed over the first non-conductive layer 302 and the exposed portions of the interconnection trace 402. The non-conductive layer 602 is deposited or otherwise applied on the top surface of the semiconductor die 202. The non-conductive layer 602 is patterned to form an opening through the non-conductive layer 602 such that the central opening 506 is void of the non-conductive layer 602. The patterned opening through the non-conductive layer 602 is located directly over the SBM structure 502 such that the portion of the interconnection trace 402 at the bottom of the central opening 506 remains exposed. In this embodiment, a portion of the non-conductive layer 602 surrounds an outer perimeter of the SBM structure 502.

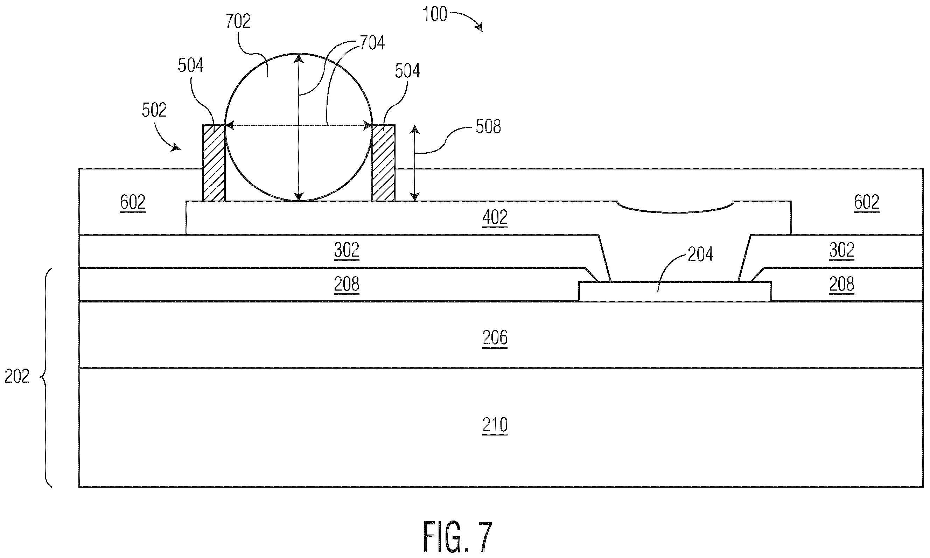

FIG. 7 illustrates, in a simplified cross-sectional view, the example semiconductor device 100 at a subsequent stage of manufacture in accordance with an embodiment. At this stage of manufacture, the semiconductor device 100 includes a ball connector 702 placed into the central opening of the SBM structure 502. When placed into the SBM structure, the plurality of vertical metal wall segments 504 substantially surrounds the ball connector 702. In this embodiment, the ball connector 702 may be characterized as a solder ball being formed from a solder or solder alloy material. In some embodiments, the ball connector 702 may be formed as a solder coated spere having a solid metal core (e.g., copper, copper alloy). In this embodiment, the ball connector 702 is a substantially round sphere having a maximum diameter dimension 704. In this embodiment, it is desirable for the height dimension 508 of the vertical metal wall segments 504 to be approximately in a range of 40-60% of the maximum diameter dimension 704 the ball connector 702. By keeping the vertical metal wall segments height dimension 508 roughly half of the ball connector diameter dimension 704, an ample dome of ball connector material will remain above the top of the vertical metal wall segments 504 after reflowing at a subsequent stage.

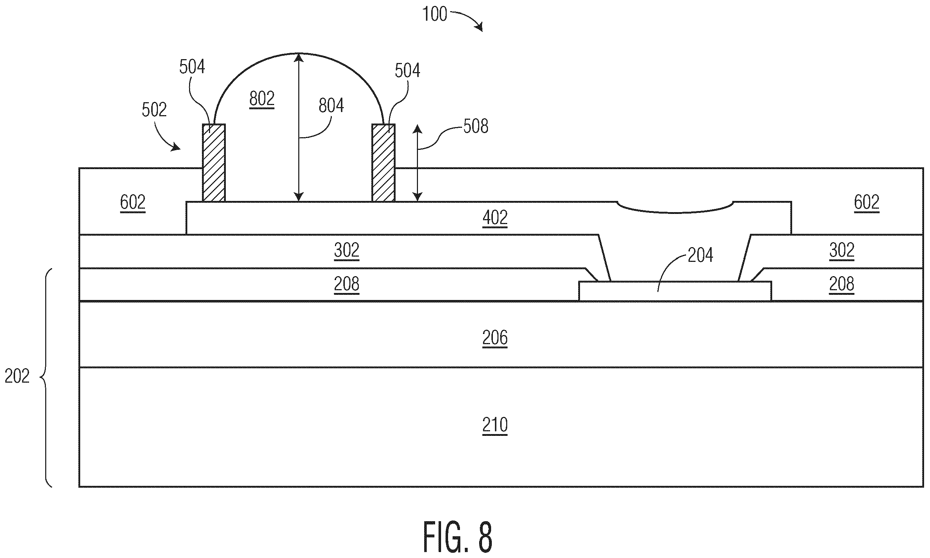

FIG. 8 illustrates, in a simplified cross-sectional view, the example semiconductor device 100 at a subsequent stage of manufacture in accordance with an embodiment. At this stage of manufacture, the semiconductor device 100 includes a reflowed ball connector 802 (e.g., reflowed solder ball) wetted to the SBM structure 502 and underlying portion of the interconnection trace 402. In this embodiment, the semiconductor device is subjected to a reflow thermal cycle such that the ball connector 702 depicted in FIG. 7 is reflowed to form the reflowed ball connector 802 depicted in FIG. 8. During the reflow thermal cycle, the ball connector material melts and wets to the inner sidewall surfaces of the SBM structure while venting any potentially trapped air or gases through the vertical gaps located between the vertical metal wall segments 504. In this embodiment, the ball connector material melts and is wetted to the inner sidewalls of the plurality of vertical metal wall segments 504 and the portion of the trace 402 surrounded by the plurality of vertical metal wall segments 504 exposed at the bottom of the SBM structure 502. By reflowing the ball connector 802 in this manner, a robust and reliable joint and connection with the SBM structure 502 is formed without voids.

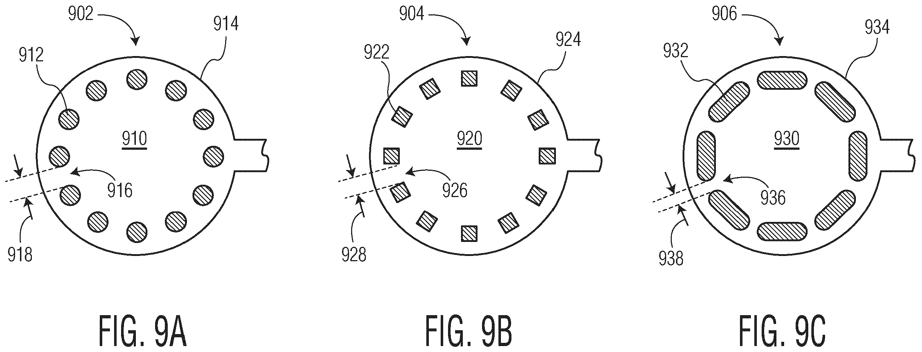

FIG. 9A through FIG. 9C illustrate, in simplified plan views, example SBM structures of the semiconductor device 100 at a stage of manufacture in accordance with an embodiment. Each of the plan views depicted in FIG. 9A through FIG. 9C include a focused portion of the semiconductor device 100 showing example alternative SBM structures for the SBM structure 108 and consistent with the stage of manufacture depicted in FIG. 1.

FIG. 9A illustrates, in a simplified plan view, the focused portion of the example semiconductor device 100 with an example SBM structure 902 in accordance with an embodiment. In this embodiment, the SBM structure 902 includes a plurality of vertical metal wall segments 912 substantially surrounding a central opening 910. In this embodiment, each of the vertical metal wall segments 912 is formed as a substantially round vertical wall segment. The plurality of vertical metal wall segments 912 of the SBM structure 902 may be formed as electroplated copper pillars, for example. The plurality of vertical metal wall segments 912 are arranged in a series around an outer perimeter base portion of the interconnection trace 914. Each of the vertical metal wall segments 912 is separated from a neighboring vertical metal wall segment by a vertical gap 916. In this embodiment, the vertical gap is formed having a predetermined lateral width dimension 918 in a range with a minimum value of approximately 10 microns and maximum value chosen such that reflowed ball connector material does not significantly flow past an outer perimeter of the SBM structure 902.

FIG. 9B illustrates, in a simplified plan view, the focused portion of the example semiconductor device 100 with an example SBM structure 904 in accordance with an embodiment. In this embodiment, the SBM structure 904 includes a plurality of vertical metal wall segments 922 substantially surrounding a central opening 920. In this embodiment, each of the vertical metal wall segments 922 is formed as a substantially square or rectilinear vertical wall segment. The plurality of vertical metal wall segments 922 of the SBM structure 904 may be formed as electroplated copper pillars, for example. The plurality of vertical metal wall segments 922 are arranged in a series around an outer perimeter base portion of the interconnection trace 924. Each of the vertical metal wall segments 922 is separated from a neighboring vertical metal wall segment by a vertical gap 926. In this embodiment, the vertical gap is formed having a predetermined lateral width dimension 928 in a range with a minimum value of approximately 10 microns and maximum value chosen such that reflowed ball connector material does not significantly flow past an outer perimeter of the SBM structure 904.

FIG. 9C illustrates, in a simplified plan view, the focused portion of the example semiconductor device 100 with an example SBM structure 906 in accordance with an embodiment. In this embodiment, the SBM structure 906 includes a plurality of vertical metal wall segments 932 substantially surrounding a central opening 930. In this embodiment, each of the vertical metal wall segments 932 is formed as a substantially oval vertical wall segment. The plurality of vertical metal wall segments 932 of the SBM structure 906 may be formed as electroplated copper pillars, for example. The plurality of vertical metal wall segments 932 are arranged in a series around an outer perimeter base portion of the interconnection trace 934. Each of the vertical metal wall segments 932 is separated from a neighboring vertical metal wall segment by a vertical gap 936. In this embodiment, the vertical gap is formed having a predetermined lateral width dimension 938 in a range with a minimum value of approximately 10 microns and maximum value chosen such that reflowed ball connector material does not significantly flow past an outer perimeter of the SBM structure 906.

Generally, there is provided, a method including forming a first non-conductive layer over a top side a semiconductor die; patterning the first non-conductive layer to form an opening exposing a top surface of a bond pad of the semiconductor die; forming a metal trace of a redistribution layer (RDL) over a portion of the first non-conductive layer and exposed top surface of the bond pad; and forming a surrounding bump metallization (SBM) structure on a portion of the metal trace, the SBM structure including a plurality of vertical metal wall segments surrounding a central opening. The method may further include placing a ball connector into the central opening of the SBM structure such that the plurality of vertical metal wall segments substantially surround the ball connector. A height dimension of the plurality of vertical metal wall segments may be approximately in a range of 40% to 60% of the largest diameter of the ball connector. The method further include reflowing the ball connector such that conductive material of the ball connector wets to the entire inner sidewalls of the plurality of vertical metal wall segments of the SBM. The each of the vertical metal wall segments of plurality of vertical metal wall segments be separated from a neighboring vertical metal wall segment by a respective gap, the gap having a predetermined lateral dimension. The predetermined lateral dimension of the gap may be substantially 10 microns or greater. The gap may extend vertically from the portion of the metal trace to a top of the plurality of vertical metal wall segments. The forming the SBM structure may include forming the plurality of vertical metal wall segments as electroplated copper pillars. The method may further include forming a second non-conductive layer over the first non-conductive layer and exposed portions of the metal trace; and patterning the second non-conductive layer such that a top surface of the metal trace is exposed in the central opening of the SBM structure.

In another embodiment, there is provided, a semiconductor device including a first non-conductive layer over a top side a semiconductor die, an opening in the first non-conductive layer exposes a top surface of a bond pad of the semiconductor die; a metal trace of a redistribution layer formed over a portion of the first non-conductive layer and exposed top surface of the bond pad; and a surrounding bump metallization (SBM) structure formed on a portion of the metal trace, the SBM structure including a plurality of vertical metal wall segments surrounding a central opening. The plurality of vertical metal wall segments of the SBM structure may be formed as electroplated copper pillars. A height dimension of the plurality of vertical metal wall segments may be substantially in a range of 40% to 60% of a horizontal width or diameter of the central opening. The semiconductor device further includes a reflowed ball connector surrounded by the plurality of vertical metal wall segments such that conductive material of the ball connector is wetted to the inner sidewalls of the plurality of vertical metal wall segments and to the portion of the metal trace. A height dimension of the plurality of vertical metal wall segments may be at least 50% of a maximum height dimension of the reflowed ball connector. Each vertical metal wall segment of the plurality of vertical metal wall segments may be separated from a neighboring vertical wall segment by way of a gap, the gap having a predetermined lateral dimension.

In yet another embodiment, there is provided, a method including forming a first non-conductive layer over a top side a semiconductor die; patterning the first non-conductive layer to form an opening exposing a top surface of a bond pad of the semiconductor die; forming a metal trace of a redistribution layer (RDL) over a portion of the first non-conductive layer and exposed top surface of the bond pad; forming a surrounding bump metallization (SBM) structure on a portion of the metal trace, the SBM structure including a plurality of vertical metal wall segments surrounding a central opening, each vertical metal wall segment separated from a neighboring vertical wall segment by way of a vertical gap; forming a second non-conductive layer over the first non-conductive layer and exposed portions of the metal trace; and patterning the second non-conductive layer such that a top surface of the metal trace is exposed in the central opening of the SBM structure. The method may further include placing a ball connector into the central opening of the SBM structure such that the plurality of vertical metal wall segments substantially surround the ball connector. The method may further include reflowing the ball connector such that conductive material of the ball connector wets to the entire inner sidewalls of the plurality of vertical metal wall segments of the SBM structure and to the portion of the metal trace. The vertical gap may be formed having a predetermined lateral dimension, the predetermined lateral dimension substantially 10 microns or greater. The plurality of vertical metal wall segments of the SBM structure may be formed as electroplated copper pillars.

By now, it should be appreciated that there has been provided a semiconductor device with a surrounding bump metallization. The semiconductor device includes a patterned redistribution layer. A plurality of interconnections traces are formed from the patterned redistribution layer. Each interconnection trace includes a first portion connected to a top surface of a respective bond pad and a second portion configured as a base for formation of a surrounding bump metallization structure. A plurality of surrounding bump metallization structures are formed on respective interconnection traces. Each of surrounding bump metallization structure includes a plurality of vertical metal wall segments formed around an outer perimeter region of the second portion of the interconnection trace. A central opening or cavity is formed by the surrounding plurality of the vertical metal wall segments. Each of the vertical metal wall segments is separated from a neighboring vertical metal wall segment by a vertical gap. Each of the surrounding bump metallization structures is configured to serve as a socket for receiving a ball connector. The vertical gap allows air to vent as the ball connector material is melted. The width of the gap is chosen such that it is large enough for air to escape and small enough to keep the melted ball connector material from oozing out of the socket. By forming the surrounding bump metallization structures in this manner, the ball connections with semiconductor device are more robust and provide superior reliability along with tighter ball pitch control.

The terms "front," "back," "top," "bottom," "over," "under" and the like in the description and in the claims, if any, are used for descriptive purposes and not necessarily for describing permanent relative positions. It is understood that the terms so used are interchangeable under appropriate circumstances such that the embodiments of the invention described herein are, for example, capable of operation in other orientations than those illustrated or otherwise described herein.

Although the invention is described herein with reference to specific embodiments, various modifications and changes can be made without departing from the scope of the present invention as set forth in the claims below. Accordingly, the specification and figures are to be regarded in an illustrative rather than a restrictive sense, and all such modifications are intended to be included within the scope of the present invention.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such element.

## Claims

1. A method comprising:
forming a first non-conductive layer (302) over a top side a semiconductor die (102);
patterning the first non-conductive layer to form an opening (114) exposing a top surface of a bond pad (104) of the semiconductor die;
forming a metal trace (106) of a redistribution layer, RDL, over a portion of the first non-conductive layer and exposed top surface of the bond pad; and
forming a surrounding bump metallization, SBM, structure (108) on a portion of the metal trace, the SBM structure including a plurality of vertical metal wall segments surrounding a central opening, wherein the each of the vertical metal wall segments of plurality of vertical metal wall segments is separated from a neighboring vertical metal wall segment by a respective gap (112), the gap having a predetermined lateral dimension;
placing a ball connector (702) into the central opening of the SBM structure such that the plurality of vertical metal wall segments (110) substantially surround the ball connector; and reflowing the ball connector such that conductive material of the ball connector wets to the entire inner sidewalls of the plurality of vertical metal wall segments of the SBM and the reflowed ball connector is prevented from extending significantly beyond an outer perimeter formed by the plurality of vertical metal wall segments.

2. The method of claim 1, wherein a height dimension (508) of the plurality of vertical metal wall segments is approximately in a range of 40% to 60% of a largest diameter of the ball connector.

3. The method of claim 1 or claim 2, wherein the predetermined lateral dimension of the gap is substantially 10 microns or greater.

4. The method of any preceding claim, wherein the gap extends vertically from the portion of the metal trace to a top of the plurality of vertical metal wall segments.

5. The method of any preceding claim, wherein forming the SBM structure includes forming the plurality of vertical metal wall segments as electroplated copper pillars.

6. The method of any preceding claim, further comprising:
forming a second non-conductive layer (602) over the first non-conductive layer and exposed portions of the metal trace; and
patterning the second non-conductive layer such that a top surface of the metal trace is exposed in the central opening of the SBM structure.

7. A semiconductor device comprising:
a first non-conductive layer (302) over a top side a semiconductor die (102), an opening (114) in the first non-conductive layer exposes a top surface of a bond pad (204) of the semiconductor die;
a metal trace (402) of a redistribution layer formed over a portion of the first non-conductive layer and exposed top surface of the bond pad;
a surrounding bump metallization, SBM, structure (108) formed on a portion of the metal trace, the SBM structure including a plurality of vertical metal wall segments (110) surrounding a central opening (114), wherein each vertical metal wall segment of the plurality of vertical metal wall segments is separated from a neighboring vertical wall segment by way of a gap, the gap having a predetermined lateral dimension; and
a reflowed ball connector (702) surrounded by the plurality of vertical metal wall segments such that conductive material of the ball connector is wetted to the inner sidewalls of the plurality of vertical metal wall segments and to the portion of the metal trace and the reflowed ball connector is prevented from extending significantly beyond an outer perimeter formed by the plurality of vertical metal wall segments.

8. The semiconductor device of claim 7, wherein the plurality of vertical metal wall segments of the SBM structure are formed as electroplated copper pillars.

9. The semiconductor device of claim 7 or 8, wherein a height dimension (508) of the plurality of vertical metal wall segments is substantially in a range of 40% to 60% of a horizontal width or diameter of the central opening.

10. The semiconductor device any of claims 7 to 9, wherein a height dimension of the plurality of vertical metal wall segments is at least 50% of a maximum height dimension of the reflowed ball connector.

## Patentansprüche

1. Verfahren umfassend:
Bilden einer ersten nichtleitenden Schicht (302) über einer Oberseite eines Halbleiterchips (102);
Strukturieren der ersten nichtleitenden Schicht, um eine Öffnung (114) zu bilden, die eine obere Oberfläche eines Bondpads (104) des Halbleiterchips freilegt;
Bilden einer Metallbahn (106) einer Umverteilungsschicht, RDL, über einem Teil der ersten nichtleitenden Schicht und der freiliegenden oberen Oberfläche des Bondpads; und
Bilden einer umgebenden Bump-Metallisierungs-, SBM-, Struktur (108) auf einem Teil der Metallbahn, wobei die SBM-Struktur eine Mehzahl von vertikalen Metallwandsegmenten aufweist, die eine zentrale Öffnung umgeben, wobei jedes der vertikalen Metallwandsegmente der Mehrzahl von vertikalen Metallwandsegmenten von einem benachbarten vertikalen Metallwandsegment durch einen entsprechenden Spalt (112) getrennt ist, wobei der Spalt eine vorgegebene laterale Abmessung aufweist;
Platzieren eines Kugelverbinders (702) in die zentrale Öffnung der SBM-Struktur, so dass die Mehrzahl von vertikalen Metallwandsegmenten (110) den Kugelverbinder im Wesentlichen umgibt; und Aufschmelzen des Kugelverbinders, so dass leitfähiges Material des Kugelverbinders die gesamten inneren Seitenwände der Mehrzahl von vertikalen Metallwandsegmenten des SBM benetzt und der aufgeschmolzene Kugelverbinder daran gehindert wird, sich wesentlich über einen äußeren Umfang, der von der Mehrzahl von vertikalen Metallwandsegmenten gebildet wird, hinaus zu erstrecken.

2. Verfahren nach Anspruch 1, wobei eine Höhenabmessung (508) der Mehrzahl von vertikalen Metallwandsegmenten etwa in einem Bereich von 40 % bis 60 % eines größten Durchmessers des Kugelverbinders liegt.

3. Verfahren nach Anspruch 1 oder Anspruch 2, wobei die vorgegebene laterale Abmessung des Spalts im Wesentlichen 10 Mikrometer oder mehr beträgt.

4. Verfahren nach einem der vorstehenden Ansprüche, wobei sich der Spalt vertikal von dem Abschnitt der Metallbahn zu einer Oberseite der Mehrzahl von vertikalen Metallwandsegmenten erstreckt.

5. Verfahren nach einem der vorstehenden Ansprüche, wobei Bilden der SBM-Struktur Bilden der Mehrzahl von vertikalen Metallwandsegmenten als elektroplattierte Kupfersäulen umfasst.

6. Verfahren nach einem der vorstehenden Ansprüche, ferner umfassend:
Bilden einer zweiten nichtleitenden Schicht (602) über der ersten nichtleitenden Schicht und freiliegenden Teilen der Metallbahn; und
Strukturieren der zweiten nichtleitenden Schicht, so dass eine obere Oberfläche der Metallbahn in der zentralen Öffnung der SBM-Struktur freigelegt wird.

7. Halbleitervorrichtung umfassend:
eine erste nichtleitende Schicht (302) über einer Oberseite eines Halbleiterchips (102), wobei eine Öffnung (114) in der ersten nichtleitenden Schicht eine obere Oberfläche eines Bondpads (204) des Halbleiterchips freilegt;
eine Metallbahn (402) einer Umverteilungsschicht, die über einem Teil der ersten nichtleitenden Schicht und der freiliegenden oberen Oberfläche des Bondpads gebildet ist;
eine umgebende Bump-Metallisierungs-, SBM-, Struktur (108), die auf einem Teil der Metallbahn gebildet ist, wobei die SBM-Struktur eine Mehrzahl von vertikalen Metallwandsegmenten (110) aufweist, die eine zentrale Öffnung (114) umgeben, wobei jedes vertikale Metallwandsegment der Mehrzahl von vertikalen Metallwandsegmenten von einem benachbarten vertikalen Wandsegment durch einen Spalt getrennt ist, wobei der Spalt eine vorgegebene laterale Abmessung aufweist; und
einen aufgeschmolzenen Kugelverbinder (702), der von der Mehrzahl von vertikalen Metallwandsegmenten umgeben ist, so dass leitfähiges Material des Kugelverbinders die Innenseitenwände der Mehrzahl von vertikalen Metallwandsegmenten und den Abschnitt der Metallbahn benetzt und der aufgeschmolzene Kugelverbinder daran gehindert wird, sich wesentlich über einen Außenumfang, der von der Mehrzahl von vertikalen Metallwandsegmenten gebildet wird, hinaus zu erstrecken.

8. Halbleitervorrichtung nach Anspruch 7, wobei die Mehrzahl von vertikalen Metallwandsegmenten der SBM-Struktur als elektroplattierte Kupfersäulen gebildet ist.

9. Halbleitervorrichtung nach Anspruch 7 oder 8, wobei eine Höhenabmessung (508) der Mehrzahl von vertikalen Metallwandsegmenten im Wesentlichen in einem Bereich von 40 % bis 60 % einer horizontalen Breite oder eines horizontalen Durchmessers der zentralen Öffnung liegt.

10. Halbleitervorrichtung nach einem der Ansprüche 7 bis 9, wobei eine Höhenabmessung der Mehrzahl von vertikalen Metallwandsegmenten wenigstens 50 % einer maximalen Höhenabmessung des aufgeschmolzenen Kugelverbinders beträgt.

## Revendications

1. Procédé comprenant :
la formation d'une première couche non conductrice (302) sur un côté supérieur d'une puce de semi-conducteur (102) ;
la formation de motifs sur la première couche non conductrice pour former une ouverture (114) exposant une surface supérieure d'un plot de connexion (104) de la puce de semi-conducteur ;
la formation d'une trace métallique (106) d'une couche de redistribution, RDL, sur une partie de la première couche non conductrice et sur une surface supérieure exposée du plot de connexion ; et
la formation d'une structure de métallisation de bosse environnante, SBM (108), sur une partie de la trace métallique, la structure SBM comprenant une pluralité de segments de paroi métallique verticaux entourant une ouverture centrale, chacun des segments de paroi métallique verticaux de la pluralité de segments de paroi métallique verticaux étant séparé d'un segment de paroi métallique vertical voisin par un intervalle respectif (112), l'intervalle ayant une dimension latérale prédéterminée ;
le placement d'un connecteur à bille (702) dans l'ouverture centrale de la structure SBM de sorte que la pluralité de segments de paroi métallique verticaux (110) entourent sensiblement le connecteur à bille ; et la refusion du connecteur à bille de sorte que le matériau conducteur du connecteur à bille s'imbibe sur la totalité des parois latérales internes de la pluralité de segments de paroi métallique verticaux du SBM et que le connecteur à bille refondu est empêché de s'étendre sensiblement au-delà d'un périmètre externe formé par la pluralité de segments de paroi métallique verticaux.

2. Procédé selon la revendication 1, une dimension en hauteur (508) de la pluralité de segments de paroi métallique verticaux étant approximativement dans une plage de 40 % à 60 % d'un diamètre le plus grand du connecteur à bille.

3. Procédé selon la revendication 1 ou la revendication 2, la dimension latérale prédéterminée de l'espace étant sensiblement de 10 microns ou plus.

4. Procédé selon l'une quelconque des revendications précédentes, l'espace s'étendant verticalement depuis la partie de la trace métallique jusqu'à un sommet de la pluralité de segments de paroi métallique verticaux.

5. Procédé selon l'une quelconque des revendications précédentes, la formation de la structure SBM comprenant la formation de la pluralité de segments de paroi métallique verticaux sous forme de piliers de cuivre galvanisés.

6. Procédé selon l'une quelconque des revendications précédentes, comprenant en outre :
la formation d'une seconde couche non conductrice (602) sur la première couche non conductrice et des parties exposées de la trace métallique ; et
la formation de motifs sur la seconde couche non conductrice de sorte qu'une surface supérieure de la trace métallique soit exposée dans l'ouverture centrale de la structure SBM.

7. Dispositif semi-conducteur comprenant :
une première couche non conductrice (302) sur un côté supérieur d'une puce de semi-conducteur (102), une ouverture (114) dans la première couche non conductrice exposant une surface supérieure d'un plot de connexion (204) de la puce de semi-conducteur ;
une trace métallique (402) d'une couche de redistribution formée sur une partie de la première couche non conductrice et sur la surface supérieure exposée du plot de connexion ;
une structure de métallisation de bosse environnante, SBM (108), formée sur une partie de la trace métallique, la structure SBM comprenant une pluralité de segments de paroi métallique verticaux (110) entourant une ouverture centrale (114), chaque segment de paroi métallique vertical de la pluralité de segments de paroi métallique verticaux étant séparé d'un segment de paroi vertical voisin au moyen d'un espace, l'espace ayant une dimension latérale prédéterminée ;
un connecteur à bille refondu (702) entouré par la pluralité de segments de paroi métallique verticaux de sorte que le matériau conducteur du connecteur à bille s'imbibe sur les parois latérales internes de la pluralité de segments de paroi métallique verticaux et sur la partie de la trace métallique, et le connecteur à bille refondu est empêché de s'étendre sensiblement au-delà d'un périmètre externe formé par la pluralité de segments de paroi métallique verticaux.

8. Dispositif semi-conducteur selon la revendication 7, la pluralité de segments de paroi métallique verticaux de la structure SBM étant formés sous la forme de piliers de cuivre galvanisés.

9. Dispositif semi-conducteur selon la revendication 7 ou 8, une dimension en hauteur (508) de la pluralité de segments de paroi métallique verticaux étant sensiblement dans une plage de 40 % à 60 % d'une largeur horizontale ou d'un diamètre de l'ouverture centrale.

10. Dispositif semi-conducteur selon l'une quelconque des revendications 7 à 9, une dimension en hauteur de la pluralité de segments de paroi métallique verticaux étant au moins 50 % d'une dimension en hauteur maximale du connecteur à bille refondu.
